Europäisches Patentamt

European Patent Office

Office européen des brevets

(19)

(11) Veröffentlichungsnummer: **0 006 447**
**A1**

(12) # EUROPÄISCHE PATENTANMELDUNG

(21) Anmeldenummer: 79101570.4

(22) Anmeldetag: 22.05.79

(51) Int. Cl.³: **H 03 K 5/04, H 04 L 7/02**
**// G06K15/12**

(30) Priorität: 26.06.78 DE 2827959

(71) Anmelder: **SIEMENS AKTIENGESELLSCHAFT Berlin und München, Postfach 261, D-8000 München 22 (DE)**

(43) Veröffentlichungstag der Anmeldung: 09.01.80
Patentblatt 80/1

(72) Erfinder: **Dressen, Anton, Herzog-Albrecht-Strasse 5, D-8060 Dachau (DE)**

(84) Benannte Vertragsstaaten: **AT BE CH FR GB IT NL**

(54) **Schaltungsanordnung zur Auswertung der von einem Taktgeber abgegebenen Taktgebersignale verschiedener Amplituden.**

(57) Schaltungsanordnung zur Auswertung der von einem Taktgeber abgegebenen Ausgangssignale verschiedener Amplituden und zur Erzeugung von Taktsignalen aus denselben.

Taktsignale sind erforderlich, wenn zu einem bestimmten Zeitpunkt ein Vorgang ablaufen soll. So ist zur Auslösung des Druckvorganges bei einem Drucker ein Taktsignal erforderlich. Diese Taktsignale werden mit Hilfe eines Taktgebers erzeugt, der jedesmal ein Taktgebersignal abgibt, wenn der Vorgang ablaufen soll. Das Taktgebersignal (UG) wird einer Schwellwertschaltung (TS1) zugeführt, die rechteckförmige Impulse (US) abgibt, deren Dauer von der Zeitdauer des Überschreitens der Schwelle (SC1) der Schwellwertschaltung durch die Taktgebersignale abhängt. Der Kondensator einer Entladeschaltung wird bei Auftreten der Vorderflanke des Impulses (US) von einem Anfangswert mit einem ersten Entladestrom entladen. Nach Auftreten der Rückflanke des Impulses wird der Kondensator (C12) mit einem zweiten, den doppelten Wert des ersten Entladestromes aufweisenden Entladestrom weiter entladen. Der Kondensator (C12) der Entladeschaltung ist mit einer weiteren Schwellwertschaltung (TS2) verbunden, die das Taktsignal abgibt, wenn das Potential des Kondensators einen festgelegten Schwellwert unterschreitet.

EP 0 006 447 A1

0006447

SIEMENS AKTIENGESELLSCHAFT          Unser Zeichen

Berlin und München                 VPA 78 P 2 0 3 3 EUR

**Schaltungsanordnung zur Auswertung der von einem Taktgeber abgegebenen Taktgebersignale verschiedener Amplituden**

Die Erfindung bezieht sich auf eine Schaltungsanordnung zur Auswertung der von einem Taktgeber abgegebenen Taktgebersignale verschiedener Amplituden und zur Erzeugung von Taktsignalen aus diesen Taktgebersignalen.

Taktsignale sind zur Funktion von verschiedenartigsten Geräten erforderlich. Ein Beispiel dafür ist ein Drucker. Dort muß der Zeitpunkt festgelegt werden, zu dem ein Abdruck eines Zeichens oder eines Teiles eines Zeichens durchgeführt werden soll. Es muß somit ein Taktsignal erzeugt werden, das zu diesem Zeitpunkt auftritt und einer Steuerung zugeführt wird, die den Druckmechanismus auslöst. Um ein solches Taktsignal erzeugen zu können, ist ein Weggeber oder Taktgeber erforderlich, der z.B. parallel zu der zu druckenden Zeile angeordnet ist und bei jeder Druckstelle entlang der Zeile ein Signal abgibt, das in ein Taktsignal umgewandelt wird. Ein solcher Weggeber kann z.B. bei einem Seriendrucker erforderlich sein.

Il 1 Sur / 21.6.1978

Der Taktgeber kann z.B. aus einem Glasrohr bestehen, in dem pro Druckstelle Markierungen angebracht sind. Ein Lichtstrahl trifft gleichzeitig mit dem Druckvorgang entlang der Zeile auf den Glasstab auf und tritt nur an der Stelle der Markierungen in den Glasstab ein. Im Glasstab wird das eingetretene Licht reflektiert und auf Fotoleiter geleitet, die aus dem empfangenen Licht ein elektrisches Signal erzeugen. Dieses Signal, im folgenden Taktgebersignal genannt, kann dann in das Taktsignal umgewandelt werden. Andere Ausführungen von Taktgebern sind ebenfalls möglich.

Die von dem Taktgeber abgegebenen Signale haben in der Regel unterschiedliche Höhen und unterschiedliche Basisbreiten. Zur Erzeugung der Taktsignale aus diesen Taktgebersignalen ist darum eine Schaltungsanordnung erforderlich, welche unabhängig von der Amplitude die Mitte der Taktgebersignale bewertet. Die der Erfindung zugrundeliegende Aufgabe besteht darin, eine derartige Schaltungsanordnung anzugeben. Diese Aufgabe wird dadurch gelöst, daß eine Schwellwertschaltung vorgesehen ist, der die Taktgebersignale zugeführt werden und die rechteckförmige Impulse abgibt, deren Dauer von der Zeitdauer des Überschreitens der Schwelle der Schwellwertschaltung durch die Taktgebersignale abhängt, daß eine Entladeschaltung mit einem Kondensator vorgesehen ist, bei der bei Auftreten der Vorderflanke des Impulses der Kondensator von einem Ausgangswert mit einem ersten Entladestrom entladen wird und nach einem Auftreten der Rückflanke des Impulses mit einem zweiten, den doppelten Wert des ersten Entladestromes aufweisenden Entladestrom weiterentladen wird, und daß eine weitere, mit der Entladeschaltung verbundene Schwellwertschaltung vorgesehen ist, die das Taktsignal erzeugt, wenn das Potential des Kondensators einen festgelegten Schwellwert unterschreitet.

Zweckmäßigerweise enthält die Entladeschaltung einen ersten Entladekreis mit einem ersten Entladewiderstand und einen zweiten Entladekreis mit einem zweiten Entladewiderstand. Der erste Entladekreis wird an den Kondensator der Entladeschaltung mit Hilfe eines ersten Schalters angeschlossen, wenn die Vorderflanke des Impulses auftritt. Der zweite Entladekreis wird zusätzlich durch einen zweiten Schalter an den Kondensator angeschaltet, wenn die Rückflanke des Impulses auftritt. Die Entladeschaltung enthält weiterhin einen Aufladekreis, durch den der Kondensator auf den Anfangswert wieder aufgeladen wird, wenn das Taktsignal auftritt.

Der erste Schalter kann auf einfache Weise aus einem ersten Flipflop aufgebaut sein, das bei Auftreten der Vorderflanke des Impulses von der ersten Schwellwertschaltung von einem ersten in einen zweiten Zustand gebracht wird und bei Auftreten des Taktsignales zurückgesetzt wird. Zwischen dem Ausgang des Flipflops und dem ersten Entladekreis kann zusätzlich eine Diodenschaltung angeordnet sein.

Ebenso kann der zweite Schalter aus einem zweiten Flipflop und einer Diodenschaltung bestehen. Bei Auftreten der Rückflanke des Impulses von der ersten Schwellwertschaltung wird das Flipflop von seinem einen Zustand in seinen zweiten Zustand gebracht und bei Auftreten der Impulsflanke des Taktsignales wieder zurückgesetzt. Die Diodenschaltung enthält eine Diode, die zwischen dem Kondensator der Entladeschaltung und dem zweiten Entladewiderstand des zweiten Entladekreises angeordnet ist und mindestens eine weitere Diode, die zwischen dem zweiten Entladekreis und dem zweiten Flipflop angeordnet ist.

Vorteilhafterweise kann der erste Schalter gleichzeitig den Aufladekreis für den Kondensator der Entladeschaltung bilden.

Der eine Eingang der zweiten Schwellwertschaltung ist zweckmäßigerweise mit dem Kondensator der Entladeschaltung verbunden, der Ausgang dieser Schwellwertschaltung führt zu den Rücksetzeingängen der beiden Flipflops.

Zwischen dem Ausgang der ersten Schwellwertschaltung und einem Sperreingang der ersten Schwellwertschaltung kann ein RC-Glied angeordnet sein, durch das die Schwellwertschaltung nach Auftreten der Impulsvorderflanke kurzzeitig gesperrt wird. Damit können Störimpulse, die dem Taktgebersignal überlagert sind, das zweite Flipflop nicht vorzeitig zurücksetzen.

Ein besonderer Vorteil der erfindungsgemäßen Schaltungsanordnung liegt darin, daß sie unempfindlich ist gegenüber hochfrequenten Störimpulsen.

Anhand eines Ausführungsbeispieles, das in den Figuren dargestellt ist, wird die Erfindung weiter erläutert. Es zeigen:

Fig. 1   ein Spannungsdiagramm, mit dem die prinzipielle Funktionsweise der erfindungsgemäßen Schaltungsanordnung erläutert wird,

Fig. 2   die erfindungsgemäße Schaltungsanordnung.

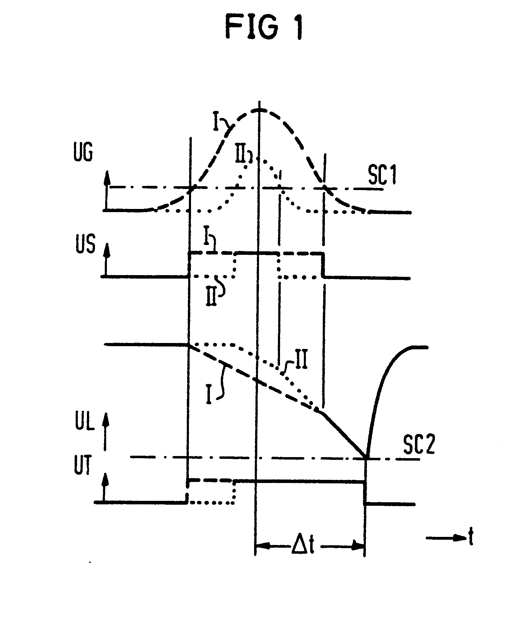

In Fig. 1 sind Spannungssignale an verschiedenen Stellen der Schaltungsanordnung aufgetragen über der Zeit t dargestellt. Mit Hilfe dieser Signale kann die prinzipielle Funktionsweise der Schaltungsanordnung zunächst erläutert werden.

Die von einem Taktgeber abgegebenen Taktgebersignale sind mit UG bezeichnet. Sie haben im Ausführungsbeispiel eine glockenförmige Form. In der Fig. 1 sind zwei mögliche Verläufe des Taktgebersignales dargestellt. Das eine Taktgebersignal I hat eine große Amplitude und eine grosse Basisbreite, das zweite Taktgebersignal II eine kleine Amplitude und eine kleine Basisbreite.

Das Taktgebersignal wird einer Schwellwertschaltung mit einem Schwellwert SC1 zugeführt. Sobald das Taktgebersignal UG den Schwellwert SC1 überschreitet, erscheint am Ausgang der Schwellwertschaltung die Vorderflanke eines rechteckförmigen Impulses, wenn das Taktgebersignal den Schwellwert SC1 wieder unterschreitet, geht der rechteckförmige Impuls am Ausgang der Schwellwertschaltung auf seinen Ausgangswert zurück. Der rechteckförmige Impuls ist in Fig. 1 mit US bezeichnet. Es ist zu sehen, daß zum Taktgebersignal I ein Impuls US mit großer Impulsbreite erzeugt wird, während zum Taktgebersignal II ein rechteckförmiger Impuls US mit kleinerer Breite entsteht. Mit Hilfe des rechteckförmigen Impulses US wird nun die Entladung eines Kondensators einer Entladeschaltung gesteuert. Mit der Vorderflanke des Impulses US wird die Entladung eines Kondensators mit einem ersten Entladestrom eingeleitet. Tritt die Rückflanke des Impulses US auf, dann wird der Entladestrom des Kondensators genau verdoppelt. Diese Verhältnisse sind bei der Spannung UL über dem Kondensator dargestellt. Es ist zu sehen, daß sich die Kurven für die Spannung UL über dem Kondensator trotz verschiedener Impulsbreiten der Impulse US nach Auftreten der Rückflanke wieder vereinigen. Voraussetzung ist, daß die Impulse zeitlich symmetrisch liegen, sie können jedoch selbst verschieden breit sein. Erreicht die Spannung UL einen zweiten Schwellwert SC2, dann wird das Taktsignal UT erzeugt, das im vorliegenden Beispiel mit der Rückflanke eines Impulses beginnt. Die Rückflanke des Impulses ist um eine bestimmte konstante Zeit $\Delta t$ von der Mitte des Taktgebersignales verschoben.

Dies muß bei der Verwendung des Taktsignales selbstverständlich berücksichtigt werden.

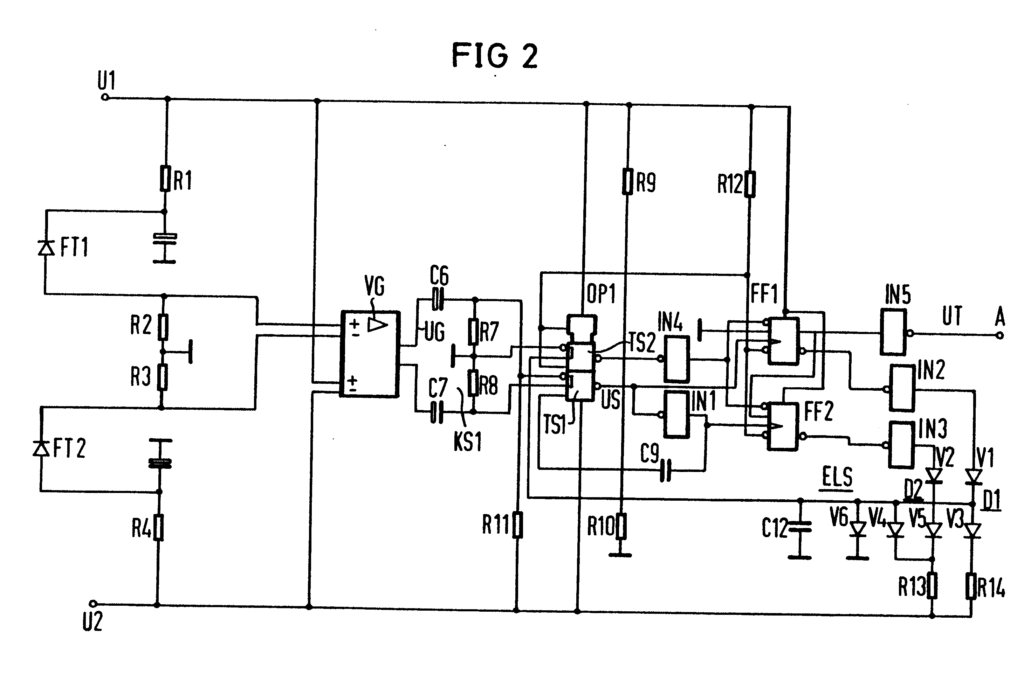

Fig. 2 zeigt eine Schaltungsanordnung, mit der das zu Fig. 1 geschilderte Funktionsprinzip realisiert werden kann. Dabei wird als Taktgeber ein Weggeber verwendet, der z.B. in der deutschen Offenlegungsschrift 25 12 349 beschrieben ist. Hier trifft ein Lichtstrahl auf einen Weggeber auf, der mit Markierungen versehen ist. Nur an der Stelle der Markierungen kann der Lichtstrahl in den Weggeber, z.B. ein Glasstab, eintreten. Das Licht wird in dem Weggeber reflektiert und gelangt zu Fotodioden. Die Fotodioden sind in Fig. 1 mit FT1 und FT2 bezeichnet. Sie geben Signale ab, die in ihrer Form dem Signal UG der Fig. 1 entsprechen. Immer wenn die Fotodiode FT1 beleuchtet wird, fließt ein Strom von einer Betriebsspannungsquelle U1, von z.B. 5 Volt, über den Widerstand R1, die Fotodiode FT1 den Widerstand R2 nach Masse. Dabei bildet sich über dem Widerstand R2 eine Spannung, die einem Verstärker VG zugeführt wird. Der Verstärker VG ist als Differenzverstärker ausgeführt. Trifft Licht auf die Fotodiode FT2 auf, so fließt ein Strom von Masse über den Widerstand R3, die Fotodiode FT2, den Widerstand R4 nach der Betriebsspannung U2. U2 hat z.B.-5 Volt. Es entsteht dabei eine Spannung über dem Widerstand R3, die ebenfalls dem Verstärker VG, und zwar am invertierenden Eingang, zugeführt wird.

Der Verstärker VG verstärkt das seinen Eingängen zugeführte Signal und erzeugt das Taktgebersignal UG. Dabei werden die von den Fotodioden FT1 und FT2 abgegebenen Signale addiert. Die Taktgebersignale UG erscheinen somit am Ausgang des Verstärkers VG und werden einem Schaltkreis KS1 zugeführt. Mit diesem Schaltkreis KS1 wird die im Taktgebersignal UG enthaltene Gleichspannungskomponente entfernt. Der Schaltkreis KS1 besteht aus Kondensatoren C6, C7 und den Widerständen R7 und R8.

Der Schaltkreis KS1 ist mit einem Operationsverstärker OP1 verbunden, der zwei Schwellwertschaltungen TS1 und TS2 enthält. Das Taktgebersignal UG wird dabei der Schwellwertschaltung TS1 zugeführt. Diese gibt den rechteckförmigen Impuls US an ihrem Ausgang ab. Die Schwellwertschaltung TS1 ist daher mit einer Schwelle SC1 versehen. Immer wenn das Taktgebersignal UG die Schwelle SC1 überschreitet, erscheint die Vorderflanke des rechteckförmigen Impulses US, wenn das Taktgebersignal UG den Schwellwert SC1 wieder unterschreitet, wird die Rückflanke des Impulses US erzeugt.

Der Impuls US wird einem ersten Flipflop FF1 direkt und einem zweiten Flipflop FF2 über einen Inverter IN1 zugeführt. Wenn die Vorderflanke des Impulses US am Ausgang der ersten Schwellwertschaltung TS1 erscheint, dann wird das Flipflop FF1 im Ausführungsbeispiel zurückgesetzt. Dies bedeutet, daß am invertierenden Ausgang Q̄1 des Flipflops FF1 die Vorderflanke eines Impulses erscheint. Der Ausgang Q̄1 des Flipflops FF1 ist mit einem weiteren Inverterglied IN2 verbunden, das mit einer ersten Diodenschaltung D1 mit Dioden V1, V3 verbunden ist. Das Flipflop FF1 und die Diodenschaltung D1 wird als erster Schalter bezeichnet.

Der Ausgang der ersten Schwellwertschaltung TS1 ist über das Inverterglied IN1 mit dem zweiten Flipflop FF2 verbunden. Dadurch wird das Flipflop FF2 dann zurückgesetzt, wenn die Rückflanke des rechteckförmigen Impulses US auftritt. Der invertierende Ausgang Q̄2 des zweiten Flipflops FF2 ist über ein Inverterglied IN3 mit einer zweiten Diodenschaltung D2 verbunden. Diese besteht aus den Dioden V2, V4, V5. Das zweite Flipflop FF2 und die zweite Diodenschaltung D2 wird als zweiter Schalter bezeichnet.

Der erste Schalter und der zweite Schalter ist Teil einer Entladeschaltung ELS, die zusätzlich noch einen Kondensator C12, einen ersten Entladekreis mit einem ersten Entladewiderstand R13 und einen zweiten Entladekreis mit einem zweiten Entladewiderstand R14 enthält. Der Ausgang der Entladeschaltung ELS ist mit der zweiten Schwellwertschaltung TS2 verbunden. Wenn die Spannung UL am Kondensator C12 den Schwellwert SC2 der Schwellwertschaltung TS2 unterschreitet, dann erscheint am Ausgang der Schwellwertschaltung TS2 die Flanke eines Impulses, der über das Invertierglied IN4 den Flipflops FF1 und FF2 zugeführt wird. Durch die Vorderflanke dieses Impulses werden dann die Flipflops FF1 und FF2 wieder in den Ausgangszustand gebracht. Dabei entsteht am Ausgang Q1 die Flanke eines Impulses, die über ein weiteres Inverterglied IN5 zum Ausgang A der Schaltungsanordnung führt. Dort tritt die Spannung UT auf. UT ist dann das Taktsignal, das durch die Schaltungsanordnung erzeugt wird.

Im Folgenden soll auf die Funktionsweise der Schaltungsanordnung eingegangen werden. Bevor die Fotodioden FT1 und FT2 beleuchtet werden, also Taktgebersignale UG auftreten, ist der Kondensator C12 der Entladeschaltung ELS auf seinen Ausgangswert von z.B. 0,7 Volt aufgeladen. Der Ausgangswert wird mit Hilfe der Diode V6 festgelegt. Die Aufladung wird dadurch erreicht, daß das erste Flipflop FF1 gesetzt ist und somit der invertierende Ausgang $\overline{Q1}$ negativ ist. Dieses negative Potential wird durch das Inverterglied IN2 invertiert, wird also positiv, so daß die Diode V1 der Diodenschaltung D1 durchlässig wird. Somit kann sich der Kondensator C12 auf seinen Ausgangswert aufladen. Der zweite Schalter, bestehend aus dem Flipflop FF2 und der Diodenschaltung D2, wird dabei nicht beeinflußt, da die Dioden V5 und V2 in Sperrichtung gepolt sind.

Werden die Fotodioden FT1 und FT2 beleuchtet, dann entstehen über den Widerständen R2 und R3 Spannungen, die dem Verstärker VG zugeführt werden. Dieser verstärkt diese Spannungen und erzeugt das Taktgebersignal UG. Das Taktgebersignal UG wird der ersten Schwellwertschaltung TS1 zugeleitet. Diese erzeugt aus ihm den rechteckförmigen Impuls US. Mit Hilfe der Vorderflanke dieses rechteckförmigen Impulses US wird das erste Flipflop FF1 zurückgesetzt. Das bedeutet, daß der invertierende Ausgang $\overline{Q1}$ des Flipflops FF1 positiv wird. Dieses Potential wird durch das Invertierglied IN2 invertiert, also negativ, so daß die Diode V1 der Diodenschaltung D1 gesperrt wird. Nun kann sich der Kondensator C12 über die Diode V3 und den ersten Entladewiderstand R13 entladen.

Tritt die Rückflanke des Impulses US auf, so wird ebenfalls das Flipflop FF2 zurückgesetzt. Damit wird der Ausgang $\overline{Q2}$ positiv, der Ausgang des Invertergliedes IN3 negativ, so daß die Diode V2 und V5 der Diodenschaltung D2 gesperrt werden. Damit kann die Diode V4 der Diodenschaltung D2 leitend werden, d.h. die Serienschaltung der Diode V4 und des zweiten Entladewiderstandes R14 wird parallel zu der Serienschaltung der Diode V3 und des ersten Entladewiderstandes R13 geschaltet. Somit entlädt sich der Kondensator C12 gleichzeitig über den ersten Entladewiderstand R13 und den zweiten Entladewiderstand R14. Wenn die Entladewiderstände gleich dimensioniert sind, wird der Entladestrom durch die Zuschaltung des zweiten Entladewiderstandes R14 verdoppelt.

Ist die Spannung UL am Kondensator C12 soweit gesunken, daß der Schwellwert SC2 der zweiten Schwellwertschaltung TS2 unterschritten wird, so gibt die Schwellwertschaltung TS2 ein Signal ab, das invertiert beiden Flipflops FF1 und FF2 zugeführt wird. Damit werden die Flipflops FF1 und FF2 wieder gesetzt. Die Folge ist, daß am Ausgang A die Flanke des Taktsignales auftritt und außerdem die Diode V1 wieder leitend wird und sich der Kondensator C12 wieder auf seinen Ausgangswert aufladen kann. Damit ist der Ausgangszustand der Schaltungsanordnung erreicht.

Die Diode V1 der ersten Diodenschaltung dient dazu, das Inverterglied IN2 von dem Kondensator C12 zu entkoppeln, wenn das Flipflop FF1 zurückgesetzt ist. Wäre die Diode V1 nicht vorhanden, so würde das Potential am Kondensator C12 durch das Ausgangspotential des Invertergliedes IN2 beeinflußt. Die Diode V4 ist angefügt, um eine Entladung des Kondensators C12 über den Widerstand R14 so lange zu verhindern, bis auch das Flipflop FF2 zurückgesetzt ist. Die Dioden V2 und V5 sind ebenfalls Entkopplungsdioden.

Mit Hilfe eines Widerstandes R11, der mit einem Eingang der ersten Schwellwertschaltung TS1 verbunden ist, wird dieser einer Vorspannung zugeführt. Dadurch wird das Auftreten von Kippschwingungen bei fehlendem Taktgebersignal verhindert.

Mit Hilfe einer RC-Kombination, bestehend aus den Widerständen R9 und R10 und einem Kondensator C9, die zwischen dem Ausgang der ersten Schwellwertschaltung TS1 und einem Eingang angeordnet ist, wird diese Schwellwertschaltung nach Auftreten der Vorderflanke des Impulses eine gewisse Zeit lang, z.B. 500 ns gesperrt. Damit können sich Störimpulse, die den Taktgeberimpulsen überlagert sind, nicht auf das zweite Flipflop FF2 vorzeitig auswirken und dieses zurücksetzen.

Die übrigen, in Fig. 2 dargestellten Kondensatoren und Widerstände dienen zur Siebung bzw. zur Einstellung von Arbeitspunkten. Da sie für die prinzipielle Wirkungsweise der Schaltungsanordnung unbedeutend sind, ist auf sie
nicht näher eingegangen worden.

7 Patentansprüche
2 Figuren

## Bezugszeichenliste

| | |
|---|---|
| FT1, FT2 | Fotodioden |
| VG | Verstärker |
| KS1 | Schaltkreis zur Entfernung der Gleichstromkomponente des Taktgebersignales UG |
| OP1 | Operationsverstärker |
| TS1 | Schwellwertschaltung |
| TS2 | Schwellwertschaltung |
| IN1 .. IN5 | Inverterglieder |
| FF1, FF2 | Flipflops |
| Q1 | Ausgang des Flipflops FF1 |
| $\overline{Q1}$ | Invertierender Ausgang des Flipflops FF1 |
| $\overline{Q2}$ | Invertierender Ausgang des Flipflops FF2 |
| D1, D2 | Diodenschaltungen |
| V1 .. V6 | Dioden |
| C12 | Kondensator |
| ELS | Entladeschaltung |
| A | Ausgang |
| R | Widerstände |
| C | Kondensatoren |
| U1, U2 | Betriebsspannungen |
| UG | Taktgebersignal |
| US | Rechteckförmiger Impuls |
| UT | Taktsignal |
| UL | Spannung am Kondensator C12 |

0006447

Patentansprüche

1. Schaltungsanordnung zur Auswertung der von einem Taktgeber abgegebenen Taktgebersignale verschiedener Amplituden und zur Erzeugung von Taktsignalen aus diesen, d a d u r c h   g e k e n n z e i c h n e t , daß eine Schwellwertschaltung (TS1) vorgesehen ist, der die Taktgebersignale (UG) zugeführt werden und die rechteckförmige Impulse (US) abgibt, deren Dauer von der Zeitdauer des Überschreitens der Schwelle (SC1) der Schwellwertschaltung durch die Taktgebersignale abhängt, daß eine Entladeschaltung (ELS) mit einem Kondensator (C12) vorgesehen ist, bei der bei Auftreten der Vorderflanke des Impulses (US) der Kondensator von einem Ausgangswert mit einem ersten Entladestrom entladen wird und nach einem Auftreten der Rückflanke des Impulses mit einem zweiten, den doppelten Wert des ersten Entladestromes aufweisenden Entladestrom weiter entladen wird, und daß eine weitere mit der Entladeschaltung verbundene Schwellwertschaltung (TS2) vorgesehen ist, die das Taktsignal (UT) erzeugt, wenn das Potential (UL) des Kondensators (C12) einen festgelegten Schwellwert (SC2) unterschreitet.

2. Schaltungsanordnung nach Anspruch 1, g e k e n n -z e i c h n e t   durch die Entladeschaltung (ELS) aus dem Kondensator (C12), aus einem ersten Entladekreis mit einem ersten Entladewiderstand (R13), aus einem ersten Schalter (FF1, D1), der den ersten Entladekreis an den Kondensator anschaltet, wenn die Vorderflanke des Impulses (US) auftritt, aus einem zweiten Entladekreis mit einem zweiten Entladewiderstand (R14), aus einem zweiten Schalter (FF2, D2), der den zweiten Entladekreis zusätzlich an den Kondensator anschaltet, wenn die Rückflanke des Impulses auftritt und aus einem Aufladekreis, durch den der Kondensator auf den Anfangswert aufgeladen wird, wenn die Impulsflanke des Taktsignales (UT) auftritt.

3. Schaltungsanordnung nach Anspruch 2, d a d u r c h
g e k e n n z e i c h n e t , daß der erste Schalter
aus einem ersten Flipflop (FF1), das bei Auftreten der
Vorderflanke des Impulses (US) von einem ersten in einen
zweiten Zustand gebracht wird und bei Auftreten der Impulsflanke des Taktsignales zurückgesetzt wird, und aus
einer, zwischen dem Ausgang des Flipflops (FF1) und dem
ersten Entladekreis angeordneten Diodenschaltung (D1) besteht.

4. Schaltungsanordnung nach Anspruch 2 oder 3, d a -
d u r c h   g e k e n n z e i c h n e t , daß der zweite Schalter aus einem zweiten Flipflop (FF2), das bei Auftreten der Rückflanke des Impulses (US) von einem ersten
in einen zweiten Zustand gebracht wird und bei Auftreten
der Impulsflanke des Taktsignales (UT) zurückgesetzt
wird und aus einer Diodenschaltung (D2) mit einer zwischen dem Kondensator (C12) und dem zweiten Entladewiderstand (R14) angeordneten Diode (V4) und mindestens einer
zwischen dem zweiten Entladewiderstand (R14) und dem zweiten Flipflop (FF2) angeordneten Diode (V5) besteht.

5. Schaltungsanordnung nach einem der Ansprüche 2 bis 4,
d a d u r c h   g e k e n n z e i c h n e t , daß der
erste Schalter (FF1, D1) gleichzeitig den Aufladekreis
für den Kondensator bildet.

6. Schaltungsanordnung nach einem der vorhergehenden Ansprüche, d a d u r c h   g e k e n n z e i c h n e t ,
daß ein Eingang der zweiten Schwellwertschaltung (TS2)
mit dem Kondensator (C12) verbunden ist und daß der Ausgang der zweiten Schwellwertschaltung an die Rücksetzeingänge der beiden Flipflops (FF1, FF2) angeschlossen
ist.

7. Schaltungsanordnung nach einem der vorhergehenden Ansprüche, d a d u r c h   g e k e n n z e i c h n e t , daß zwischen dem Ausgang der ersten Schwellwertschaltung (TS1) und einem Sperreingang dieser Schaltung ein RC-Glied (R9, R10, C9) angeordnet ist, durch die diese nach Auftreten der Vorderflanke des Impulses (US) kurzzeitig gesperrt wird.

# FIG 1

FIG 2

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | FR - A - 1 419 162 (FUJITSU)<br>* Figuren 2,3; Seite 1, rechte Spalte, Zeilen 10-29 *<br>-- | 1 |
| A | US - A - 3 906 377 (HARRIS)<br>* Figur 1; Spalte 1, Zeile 57 bis Spalte 2, Zeile 17; Spalte 2, Zeilen 31-52 *<br>-- | 1 |
| A | IBM TECHNICAL DISCLOSURE BULLETIN, Vol. 18, Nr. 8, Januar 1976, New York, US, SIMMONS: "Determining the center of an analog pulse", Seiten 2654-2655<br>* Figuren 1,2; Seiten 2654-2655 *<br>-- | 1 |
| A | IBM TECHNICAL DISCLOSURE BULLETIN, Vol. 13, Nr. 6, November 1970, New York, US, KING et al.: "Signal center timing" Seite 1593<br>* Figuren a,b; Seite 1593 *<br>---- | 1 |

**KLASSIFIKATION DER ANMELDUNG (Int.Cl.3)**

H 03 K 5/04
H 04 L 7/02//
G 06 K 15/12

**RECHERCHIERTE SACHGEBIETE (Int. Cl.²)**

H 03 K 5/04
5/08
5/153
H 04 L 7/02
G 06 K 15/12
15/10
15/14

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 25-09-1979 | LEDRUT |

EPA form 1503.1 06.78